(19) **Europäisches Patentamt**

**European Patent Office**

**Office européen des brevets**

(11) **EP 0 642 247 B1**

(12) **EUROPÄISCHE PATENTSCHRIFT**

(45) Veröffentlichungstag und Bekanntmachung des Hinweises auf die Patenterteilung:
**05.04.2000 Patentblatt 2000/14**

(51) Int. Cl.⁷: **H04M 1/60**, H03F 1/30, H03G 3/34

(21) Anmeldenummer: **94112399.4**

(22) Anmeldetag: **09.08.1994**

(54) **Lauthöreinrichtung für Fernsprechgeräte**

Loudspeaking device for telephone sets

Dispositif haut-parleur pour postes téléphoniques

(84) Benannte Vertragsstaaten:
**DE FR GB IT**

(30) Priorität: **02.09.1993 DE 4329638**

(43) Veröffentlichungstag der Anmeldung:
**08.03.1995 Patentblatt 1995/10**

(73) Patentinhaber:
**TEMIC Semiconductor GmbH**
**74072 Heilbronn (DE)**

(72) Erfinder:
• **Kühnle, Joachim**
  **D-74235 Erlenbach (DE)**
• **Röper, Wolfgang**
  **D-74549 Wolpertshausen (DE)**
• **Schnabel, Jürgen**
  **D-74211 Leingarten (DE)**

(74) Vertreter:
**Maute, Hans-Jürgen, Dipl.-Ing. et al**
**Daimler-Benz Aktiengesellschaft,**
**FTP/H,**
**Postfach 35 35**
**74025 Heilbronn (DE)**

(56) Entgegenhaltungen:
**EP-A- 0 043 707**          **EP-A- 0 159 079**
**EP-A- 0 344 510**

• **PATENT ABSTRACTS OF JAPAN vol. 5 no. 125 (E-69) [797] ,12.August 1981 & JP-A-56 061808 (SANYO DENKI K.K.) 27.Mai 1981,**

**Beschreibung**

Lauthöreinrichtungen für Fernsprechschalt-kreise (Telefonsprechkreise, Gegensprechanlagen, Funkgeräte etc.) bestehen aus einer Verstärkerschaltung als Lauthörendstufe und einem Lautsprecher. Unipolare Verstärkerschaltungen mit asymmetrischem Ausgang (die ein Verstärkerelement und einen Koppelkondensator zur Abtrennung des Gleichstroms aufweisen) haben gegenüber symmetrischen Lauthörendstufen neben der geringeren Komplexität und des geringeren Platzbedarfs auch den Vorteil der höheren Stromeffizienz, das heißt bei den üblichen Lautsprecherimpedanzen von 30 bis 100 Ω besitzen sie eine größere Ausgangsleistung im kritischen Bereich kleiner Versorgungsströme.
Nachteilig beim Einsatz dieser Lauthörendstufen ist jedoch, daß beim Einschalten des Lautsprechers ein lautes und störendes Knackgeräusch hörbar wird, das durch den hohen Stromimpuls beim schlagartigen Aufladen des Koppelkondensators hervorgerufen wird - siehe hierzu auch EP-A-0 043 707.
Es ist Aufgabe der Erfindung, eine einfache Lauthöreinrichtung anzugeben, bei der die störenden Knackgeräusche beim Zuschalten des Lautsprechers nicht auftreten. Diese Aufgabe wird erfindungsgemäß durch die Merkmale des Patentanspruches 1 gelöst.
Vorteilhafte Weiterbildungen der Erfindung ergeben sich aus den Unteransprüchen.
Der Erfindung liegt die Erkenntnis zugrunde, daß das Anlegen einer Gleichspannung an den Lautsprecher unterhalb eines bestimmten Spannungs-Schwellwerts (beispielsweise 20 mV) praktisch unhörbar ist; dies entspricht - abhängig vom Widerstandswert des Lautsprechers - einem definierten Strom-Schwellwert (beispielsweise beträgt dieser Strom-Schwellwert ca. 400 μA bei 20 mV Gleichspannung und einem Widerstand von 50 Ω). Bei der vorgestellten Lauthöreinrichtung werden mittels einer Hilfsschaltung aus Sollwertvorgabeglied, Speicherglied, strombegrenzten Spannungsfolgerverstärker und Vergleichselement folgende Maßnahmen getroffen:

- der Koppelkondensator wird beim Anlegen der Betriebsspannung an den Fernsprechschaltkreis mit einem unterhalb dem Strom-Schwellwert liegenden Ladestrom auf einen bestimmten Ladungszustand vorgeladen (dieser Vorladevorgang tritt demzufolge für den Benutzer nicht in Erscheinung); der Ladungszustand des Kondensators wird abhängig einerseits vom Offset der Eingangssignalspannung und andererseits von der maximal zulässigen Zeit vom Eintreffen bis zum Durchschalten eines Einschaltbefehls für den Lautsprecher (bzw. für die Lauthörendstufe) gewählt

- beim Zuschalten des Lautsprechers wird der bereits vorgeladene Kondensator mit dem "unkritischen" Ladestrom weiter aufgeladen

- das Eingangssignal wird erst dann auf den Lautsprecher ausgegeben, wenn die Spannung am Ausgang des Verstärkerelements der Lauthörendstufe die Eingangssignalspannung erreicht hat.

Die Lauthöreinrichtung vereinigt mehrere Vorteile in sich:

- dadurch daß die Ladeströme zum Aufladen des Koppelkondensators unterhalb des "kritischen" Strom-Schwellwerts gewählt werden, ist eine knackfreie Einschaltung des Lautsprechers bei allen asymmetrischen Lauthörendstufen sicherge-stellt, beispielsweise solcher in Telefonschaltkrei-sen

- dadurch daß der Aufladevorgang des Koppelkondensators in zwei Stufen durchgeführt wird (Vorladen des Koppelkondensators auf diejenige Spannung, die ein knackfreies Einschalten sicher ermöglicht, endgültiges Aufladen beim Vorhandensein eines Lautsprecher-Einschaltbefehls), ist eine kurze Ansprechzeit (bis zum Durchschalten des Eingangssignals auf den Lautsprecher) gewährleistet

- dadurch daß der Koppelkondensator selbst als zeitabhängiges Glied zur "sanften Aufladung" verwendet wird, werden bei einer Integration der Lauthörendstufe keine zusätzlichen externen Bauelemente benötigt.

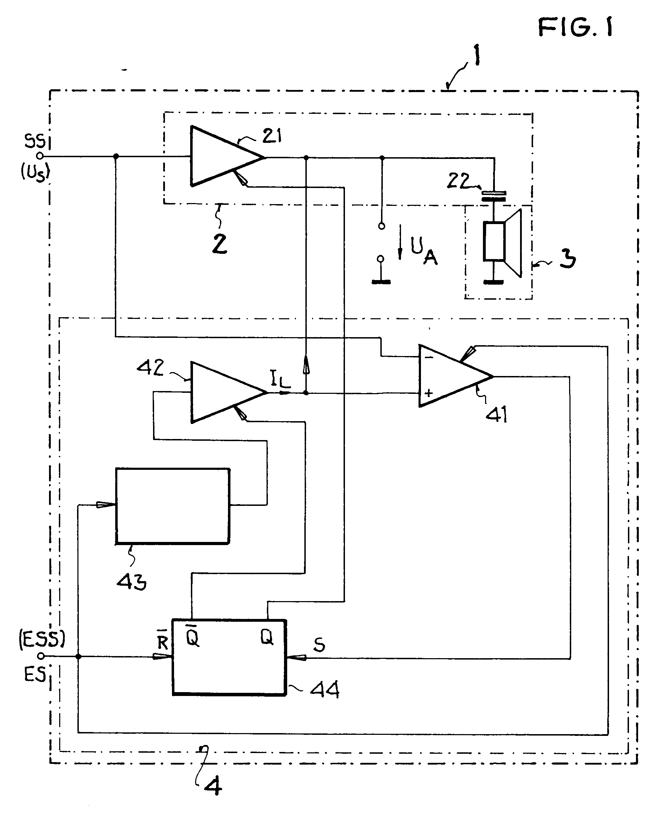

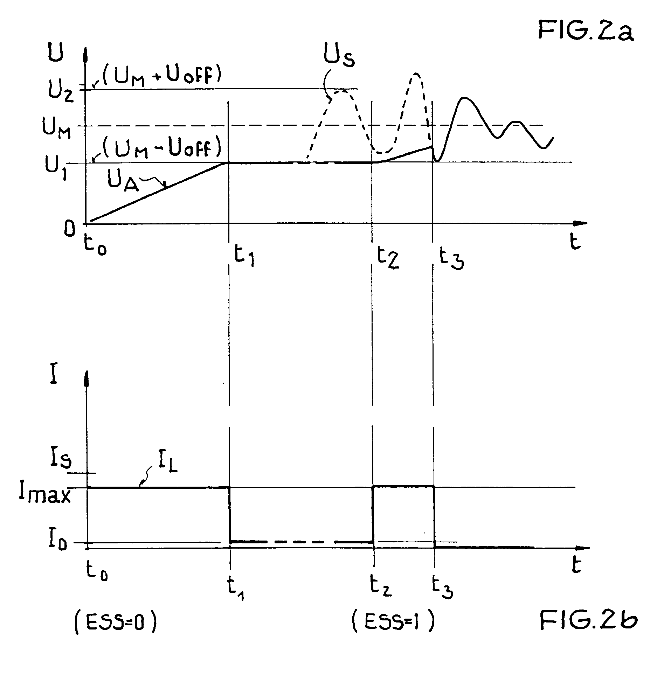

Anhand der Figuren 1 und 2 wird im folgenden ein Ausführungsbeispiel erläutert.
Die Figur 1 zeigt das Blockschaltbild einer Telefon-Lauthöreinrichtung, die Figur 2 den zeitlichen Spannungsverlauf (Figur 2a) und den zeitlichen Stromverlauf (Figur 2b) für verschiedene Betriebszustände der Lauthöreinrichtung.
Gemäß der Figur 1 besteht die Lauthöreinrichtung 1 aus der unipolaren Verstärkerschaltung 2 (Lauthörendstufe) mit Lauthörverstärkerelement 21 und Koppelkondensator 22, aus dem Lautsprecher 3 sowie aus der Hilfsschaltung 4. Die Hilfsschaltung 4 weist ein beispielsweise als Spannungskomparator ausgebildetes Vergleichselement 41, einen strombegrenzten Spannungsfolgerverstärker 42, ein Sollwertvorgabeglied 43 und ein beispielsweise als Flip-Flop ausgebildetes Speicherglied 44 auf.
Am Eingang ES der Lauthöreinrichtung 1 liegt das Einschaltsignal ESS an, über das der Lauthörverstärker 21 der Lauthörendstufe 2 bzw. der Lautsprecher 3 aktiviert (ESS = "1") oder deaktiviert (ESS = "0") wird; hierzu ist der Eingang ES mit dem invertierenden Rücksetz-Eingang R des Speicher-Flip-Flops 44, mit dem Eingang des Sollwertvorgabeglieds 43 und mit dem Steuereingang des Spannungskomparators 41 verbunden. Der Ausgang des Sollwertvorgabeglieds 43 ist mit dem Eingang des Spannungsfolgerverstärkers 42 verbunden, dessen Steuereingang vom invertierenden Ausgang $\overline{Q}$ des Speicher-Flip-Flops 44 angesteuert wird; das Sollwertvorgabeglied 43 gibt abhängig vom Zustand des Einschaltsignals ES zwei unterschiedliche Sollwerte für den Spannungsfolgerverstärker 42 vor, der einen Ausgangsstrom $I_L$ mit einem dem Maximalwert $I_{max}$ liefert (dieser Maximalwert $I_{max}$ liegt unterhalb dem "kritischen" Strom-Schwellwert $I_S$). Der Ausgang des Spannungsfolgerverstärkers 42 ist mit dem nicht-invertierenden Eingang (+) des Spannungskomparators 41, mit dem Ausgang des Lauthörverstärkers 21 und mit dem Koppelkondensator 22 verbunden. Der Eingang SS der Lauthöreinrichtung 1 für die Signalspannung $U_S$ ist mit dem Eingang des Lauthörverstärkers 21 und mit dem invertierenden Eingang (-) des Spannungskomparators 41 verbunden. Der Spannungskomparator 41 vergleicht somit die Eingangssignalspannung $U_S$ mit der Spannung $U_A$ am Ausgang des Lauthörverstärkers 21. Über das Ausgangssignal des Spannungskomparators 41 wird in Abhängigkeit dieses Spannungsvergleichs der Setz-Eingang S des Speicher-Flip-Flops 44 angesteuert und über den nicht-invertierenden Ausgang Q des Speicher-Flip-Flops 44 (dieser ist mit dem Steuereingang des Lauthörverstärkers 21 verbunden) der Lauthörverstärker 21 geschaltet; ist der Lauthörverstärker 21 durchgeschaltet, wird die Eingangssignalspannung $U_S$ über den Koppelkondensator 22 auf den Lautsprecher 3 ausgegeben. Die Hilfsschaltung 4 kann zusammen mit dem Lauthörverstärker 21 in einer integrierten Schaltung (IC) integriert werden.

Gemäß der Figur 2 wird der zeitliche Ablauf für die verschiedenen Betriebszustände der Lauthöreinrichtung beschrieben:

- Beim Einschalten des Telefons (Abnehmen des Hörers) zum Zeitpunkt $t_0$ wird die Spannungsversorgung der Lauthöreinrichtung 1 sichergestellt. Am Einschalteingang ES liegt keine Einschaltinformation an (ESS = "0"). Der vom nicht-invertierenden Ausgang Q des Speicher-Flip-Flops 44 angesteuerte Lauthörverstärker 21 ist inaktiviert, ebenso der Spannungskomparator 41; das am Signaleingang SS anliegende Eingangssignal $U_S$ wird folglich nicht auf den Lautsprecher 3 ausgegeben. Der Koppelkondensator 22 wird über den strombegrenzten Spannungsfolgerverstärker 42 mit dem Ladestrom $I_L$ aufgeladen (der Ladestrom $I_L$ ist aufgrund der Strombegrenzung auf den zulässigen Maximalwert $I_{max}$ begrenzt, aber kleiner als der "kritische" Strom-Schwellwert $I_S$, beispielsweise $I_L \cong I_{max} = 400 \ \mu A$ ). Der Endpunkt der Aufladung wird vom Sollwertvorgabeglied 43 über die Vorgabe einer Maximalspannung $U_1$ für die Ausgangsspannung $U_A$ des Lauthörverstärkers 21 eingestellt; die

Spannung $U_1$ (erster Schwellwert) wird abhängig vom (bekannten) Mittelwert $U_M$ der Eingangssignalspannung $U_S$ und unter Berücksichtigung des Maximalbetrags des Offsets $U_{Off}$ in negativer Richtung $|U_{Off' max}|$ der vorgeschalteten Stufen vorgegeben ( $U_1 \leq U_M - |U_{Off' max}|$ ). Beispielsweise liegt die Spannung $U_S$ des Eingangssignals zwischen 0 und 6,4 V ($U_M = 3,2$ V), der Betrag des Offsets $U_{Off}$ ist beispielsweise kleiner 0,4 V; der (vom Sollwertvorgabeglied 43 festgelegte) erste Schwellwert $U_1$ kann demnach 2,8 V betragen.

- Zum Zeitpunkt $t_1$ (beispielsweise nach 400 ms) erreicht die Spannung $U_A$ am Ausgang des Lauthörverstärkers 21 den vom Sollwertvorgabeglied 43 vorgegebenen ersten Schwellwert $U_1$ (der stabile Zustand ist erreicht); daraufhin wird der Aufladevorgang des Kondensators 22 mit dem durch den strombegrenzten Spannungsfolgerverstärker 42 vorgegebenen Ladestrom $I_L$ beendet (es fließt nur noch der Leckstrom $I_0$). Die Spannung $U_A$ wird somit auf dem ersten Schwellwert $U_1$ festgehalten.

- Zum Zeitpunkt $t_2$ soll der Lautsprecher zugeschaltet werden (Tastendruck), woraufhin ein Einschaltbefehl am Eingang ES angelegt wird (ESS = "1"). Hierdurch wird das Sollwertvorgabeglied 43 umgeschaltet und gibt nun eine (größere) Spannung $U_2$ als zweiten Schwellwert vor ( $U_2 \geq U_M + |U_{Off' max}|$ , beispielsweise $U_2 = 3,2 + 0,4$ V = 3,6 V); der Koppelkondensator 22 wird über den Spannungsfolgerverstärker 42 mit dem Ladestrom $I_L$ weiter aufgeladen. Gleichzeitig wird der Spannungskomparator 41 aktiviert, der die Eingangssignalspannung $U_S$ am Signaleingang SS sowie die Ausgangsspannung $U_A$ des Spannungsfolgerverstärkers 42 bzw. des Lauthörverstärkers 21 miteinander vergleicht. Der Ausgang des Spannungskomparators 41 bleibt solange auf einer logischen "0", bis der Ausgangsstrom $I_L$ des Spannungsfolgerverstärkers 42 den Koppelkondensator 22 soweit aufgeladen hat, daß Eingangsspannung $U_S$ und Ausgangsspannung $U_A$ des Lauthörverstärkers 21 übereinstimmen.

- Zum Zeitpunkt $t_3$ erreicht die Spannung $U_A$ am Ausgang des Lauthörverstärkers 21 die Eingangssignalspannung $U_S$, woraufhin über das Ausgangssignal des Spannungskomparators 41 (logische "1) das Speicher-Flip-Flop 44 gesetzt wird. Über den nicht-invertierenden Ausgang Q des Speicher-Flip-Flops 44 wird nun der Lauthörverstärker 21 aktiviert, wodurch die Lauthörendstufe 2 und der Lautsprecher 3 knackfrei eingeschaltet werden. Durch entsprechende Vorgabe der Spannungs-Schwellwerte $U_1$ und $U_2$ ist sichergestellt, daß ein Einschalten des Lautsprechers 3 sicher erfolgt (die Spannung $U_A$ erreicht die Eingangsspannung $U_S$ auf alle Fälle) und daß die Einschaltzeit des Lautsprechers 3 innerhalb einer geforderten Zeitspanne (beispielsweise 100 ms) nach dem Tastendruck liegen kann. Gleichzeitig wird zum Zeitpunkt $t_3$ der Spannungsfolgerverstärker 42 über den invertierenden Ausgang $\overline{Q}$ des Speicher-Flip-Flops 44 wieder deaktiviert, d.h. der Ladevorgang des Kondensators 22 mit dem Ladestrom $I_L$ beendet.

- Zum Wiederausschalten (Deaktivieren) der Lauthörendstufe 2 bzw. des Lautsprechers 3 muß am Eingang ES ein Ausschaltsignal angelegt werden (ESS = "0"), wodurch alle Schaltungskomponenten in den beim Einschalten des Telefons (Zeitpunkt $t_o$) beschriebenen Zustand zurückkehren.

## Patentansprüche

1. Lauthöreinrichtung (1) für Fernsprechschaltkreise, umfassend:

   a) eine als unipolare Verstärkerschaltung ausgebildete Lauthörendstufe (2) mit Lauthörverstärker (21) und Koppelkondensator (22),
   b) einen mit dem Koppelkondensator (22) verbundenen Lautsprecher (3),
   c) eine Hilfsschaltung (4) mit einem Speicherglied (44), einem Sollwertvorgabeglied (43), einem strombegrenzten Spannungsfolgerverstärker (42) und einem Vergleichselement (41).

2. Lauthöreinrichtung nach Anspruch 1, dadurch gekennzeichnet, daß der Schaltungseingang (ES) der Lauthöreinrichtung (1) für das Lautsprecher-Einschaltsignal (ESS) mit dem Rücksetz-Eingang (R) des Speicherglieds (44), dem Eingang des Sollwertvorgabeglieds (43) und dem Steuereingang des Vergleichselements (41) verbunden ist.

3. Lauthöreinrichtung nach Anspruch 1 oder 2, dadurch gekennzeichnet, daß der Ausgang des Sollwertvorgabeglieds (43) mit dem Eingang des Spannungsfolgerverstärkers (42) verbunden ist.

4. Lauthöreinrichtung nach einem der Ansprüche 1 bis 3, dadurch gekennzeichnet, daß das Sollwertvorgabeglied (43) zwei unterschiedliche Spannungswerte ($U_1$, $U_2$) vorgibt, die von der am Signaleingang (SS) der Lauthöreinrichtung (1) anliegenden Eingangssignalspannung ($U_S$) und von der Offsetspannung ($U_{Off}$) der vorgeschalteten Stufen abhängen, und daß der Spannungsfolgerverstärker (42) einen Ausgangsstrom ($I_L$) abgibt, dessen Maximalwert ($I_{max}$) kleiner als ein Strom-Schwellwert ($I_S$) gewählt wird.

5. Lauthöreinrichtung nach einem der Ansprüche 1 bis 4, dadurch gekennzeichnet, daß der Ausgang des Spannungsfolgerverstärkers (42) mit dem Ausgang des Lauthörverstärkers (21), dem positiven Eingang (+) des Vergleichselements (41) und dem Koppelkondensator (22) verbunden ist.

6. Lauthöreinrichtung nach einem der Ansprüche 1 bis 5, dadurch gekennzeichnet, daß der Signaleingang (SS) mit dem Eingang des Lauthörverstärkers (21) und dem negativen Eingang (-) des Vergleichselements (41) verbunden ist.

7. Lauthöreinrichtung nach einem der Ansprüche 1 bis 6, dadurch gekennzeichnet, daß der Ausgang des Vergleichselements (41) mit dem Setz-Eingang (S) des Speicherglieds (44) verbunden ist.

8. Lauthöreinrichtung nach einem der Ansprüche 1 bis 7, dadurch gekennzeichnet, daß der invertierende Ausgang ($\overline{Q}$) des Speicherglieds (44) mit dem Steuereingang des Spannungsfolgerverstärkers (42) und der nicht-invertierende Ausgang (Q) des Speicherglieds (44) mit dem Steuereingang des Lauthörverstärkers (21) verbunden ist.

9. Lauthöreinrichtung nach einem der Ansprüche 1 bis 8, dadurch gekennzeichnet, daß das Speicherglied (44) als Flip-Flop ausgebildet ist.

10. Lauthöreinrichtung nach einem der Ansprüche 1 bis 9, dadurch gekennzeichnet, daß das Vergleichselement (41) als Spannungskomparator ausgebildet ist.

11. Lauthöreinrichtung nach einem der Ansprüche 1 bis 10, dadurch gekennzeichnet, daß die Hilfsschaltung (4) zusammen mit dem Lauthörverstärker (21) der Lauthörendstufe (2) in einer integrierten Schaltung integriert ist.

## Claims

1. A loudspeaking device (1) for telephone circuits comprising:

   a) a loudspeaker output stage (2) in the form of a unipolar amplifying circuit incorporating a loudspeaker amplifier (21) and a coupling capacitor (22),

   b) a loudspeaker (3) connected to the coupling capacitor (22),

   c) an auxiliary circuit (4) incorporating a storage member (44), a reference member (43) producing an output signal representing a preferred value, a current limited voltage follower amplifier (42) and a comparator element (41).

**2.** A loudspeaking device in accordance with Claim 1, characterised in that the circuit input (ES) of the loudspeaking device (1) for the loudspeaker enabling signal (ESS) is connected to the reset input (R) of the storage member (44), to the input of the reference member (43) and to the control input of the comparator element (41).

**3.** A loudspeaking device in accordance with Claim 1 or 2, characterised in that the output of the reference member (43) is connected to the input of the voltage follower amplifier (42).

**4.** A loudspeaking device in accordance with any of the Claims 1 to 3, characterised in that the reference member (43) provides two different voltage values ($U_1$, $U_2$) that depend on the offset voltage ($U_{off}$) of the preceding stages and on the input signal voltage ($U_S$) present on the signal input (SS) of the loudspeaking device (1), and in that the voltage follower amplifier (42) provides an output current ($I_L$) whose maximum value ($I_{max}$) is selected to be less than a current threshold value ($I_S$).

**5.** A loudspeaking device in accordance with any of the Claims 1 to 4, characterised in that the output of the voltage follower amplifier (42) is connected to the output of the loudspeaker amplifier (21), to the positive input (+) of the comparator element (41) and to the coupling capacitor (22).

**6.** A loudspeaking device in accordance with any of the Claims 1 to 5, characterised in that the signal input (SS) is connected to the input of the loudspeaker amplifier (21) and to the negative input (-) of the comparator element (41).

**7.** A loudspeaking device in accordance with any of the Claims 1 to 6, characterised in that the output of the comparator element (41) is connected to the set input (S) of the storage member (44).

**8.** A loudspeaking device in accordance with any of the Claims 1 to 7, characterised in that the inverting output ($Q^-$) of the storage member (44) is connected to the control input of the voltage follower amplifier (42), and in that the non-inverting output (Q) of the storage member (44) is connected to the control input of the loudspeaker amplifier (21).

**9.** A loudspeaking device in accordance with any of the Claims 1 to 8, characterized in that the storage member (44) is in the form of a flip-flop.

**10.** A loudspeaking device in accordance with any of the Claims 1 to 9, characterised in that the comparator element (41) is in the form of a voltage comparator.

**11.** A loudspeaking device in accordance with any of the Claims 1 to 10, characterized in that the auxiliary circuit (4) is integrated in an integrated circuit together with the loudspeaker amplifier (21) of the loudspeaker output stage (2).

**Revendications**

**1.** Dispositif haut-parleur (1) pour circuits téléphoniques, comprenant :

(a) un étage haut-parleur (2) réalisé sous la forme d'un circuit amplificateur unipolaire avec amplificateur de haut-parleur (21) et condensateur de couplage (22),
(b) un haut-parleur (3) relié au condensateur de couplage (22),
(c) un circuit auxiliaire (4) équipé d'un élément de mémoire (44), d'un élément de prescription de valeur de consigne (43), d'un amplificateur d'asservissement de tension (42) limité en courant et d'un élément de comparaison (41).

**2.** Dispositif haut-parleur selon la revendication 1, caractérisé en ce que l'entrée de circuit (ES) du dispositif haut-parleur (1) pour le signal de mise en service du haut-parleur (ESS) est reliée à l'entrée de restauration (R) de l'élément de mémoire (44), à l'entrée de l'élément de prescription de valeur de consigne (43) et à l'entrée de commande de l'élément de comparaison (41).

**3.** Dispositif haut-parleur selon la revendication 1 ou 2, caractérisé en ce que la sortie de l'élément de prescription de valeur de consigne (43) est reliée à l'entrée de l'amplificateur d'asservissement de tension (42).

**4.** Dispositif haut-parleur selon l'une quelconque des revendications 1 à 3, caractérisé en ce que l'élément de prescription de valeur de consigne (43) prescrit deux valeurs de tension différentes ($U_1$, $U_2$) qui dépendent de la tension de signal d'entrée ($U_S$) présente à l'entrée de signal (SS) du dispositif haut-parleur (1) et de la tension de décalage ($U_{off}$) des étages disposés en amont, et en ce que l'amplificateur d'asservissement de tension (42) délivre un courant de sortie ($I_L$) dont la valeur maximale ($I_{max}$) est choisie inférieure à une valeur de seuil de courant ($I_S$).

**5.** Dispositif haut-parleur selon l'une quelconque des revendications 1 à 4, caractérisé en ce que la sortie de l'amplificateur d'asservissement de tension (42) est reliée à la sortie de l'amplificateur de haut-parleur (21), à l'entrée positive (+) de l'élément de comparaison (41) et au condensateur de couplage (22).

**EP 0 642 247 B1**

6. Dispositif haut-parleur selon l'une quelconque des revendications 1 à 5, caractérisé en ce que l'entrée de signal (SS) est reliée à l'entrée de l'amplificateur de haut-parleur (21) et à l'entrée négative (-) de l'élément de comparaison (41).

7. Dispositif haut-parleur selon l'une quelconque des revendications 1 à 6, caractérisé en ce que la sortie de l'élément de comparaison (41) est reliée à l'entrée de basculement (S) de l'élément de mémoire (44).

8. Dispositif haut-parleur selon l'une quelconque des revendications 1 à 7, caractérisé en ce que la sortie avec inversion ($\overline{Q}$) de l'élément de mémoire (44) est reliée à l'entrée de commande de l'amplificateur d'asservissement de tension (42) et la sortie sans inversion (Q) de l'élément de mémoire (44) à l'entrée de commande de l'amplificateur de haut-parleur (21).

9. Dispositif haut-parleur selon l'une quelconque des revendications 1 à 8, caractérisé en ce que l'élément de mémoire (44) est réalisé sous la forme d'une bascule.

10. Dispositif haut-parleur selon l'une quelconque des revendications 1 à 9, caractérisé en ce que l'élément de comparaison (41) est réalisé sous la forme d'un comparateur de tension.

11. Dispositif haut-parleur selon l'une quelconque des revendications 1 à 10, caractérisé en ce que le circuit auxiliaire (4) est intégré dans un circuit intégré conjointement avec l'amplificateur de haut-parleur (21) de l'étage de haut-parleur (2).

FIG. 1

FIG.2a

FIG.2b

(ESS=0)        (ESS=1)